**Europäisches Patentamt**

**European Patent Office**

**Office européen des brevets**

(19)

(11) Veröffentlichungsnummer: **0 060 862**
**B1**

(12) **EUROPÄISCHE PATENTSCHRIFT**

(45) Veröffentlichungstag der Patentschrift:
**05.12.84**

(21) Anmeldenummer: **81902653.5**

(22) Anmeldetag: **25.09.81**

(86) Internationale Anmeldenummer:
**PCT/CH 81/00106**

(87) Internationale Veröffentlichungsnummer:
**WO 82/01289 (15.04.82 Gazette 82/10)**

(51) Int. Cl.³: **H 03 D 13/00, H 03 L 7/08**

(54) **SCHALTUNGSANORDNUNG ZUR ERZEUGUNG EINER REGELSPANNUNG IN ABHÄNGIGKEIT VON DER FREQUENZ-ODER PHASENDIFFERENZ UND VERWENDUNG DER SCHALTUNGSANORDNUNG.**

(30) Priorität: **29.09.80 CH 7272/80**

(43) Veröffentlichungstag der Anmeldung:
**29.09.82 Patentblatt 82/39**

(45) Bekanntmachung des Hinweises auf die Patenterteilung:
**05.12.84 Patentblatt 84/49**

(84) Benannte Vertragsstaaten:
**AT CH DE FR GB LI NL SE**

(56) Entgegenhaltungen:
**DE - A - 2 022 231**
**DE - A - 2 260 391**
**US - A - 3 750 035**
**US - A - 4 155 045**

(73) Patentinhaber: **Hasler AG, Belpstrasse 23,**
**CH-3000 Bern 14 (CH)**

(72) Erfinder: **STEINLIN, Walter, Einschlagstrasse 21,**
**CH-3065 Bolligen (CH)**

(74) Vertreter: **Schwerdtel, Eberhard, Dr., c/o Hasler AG**
**Belpstrasse 23, CH-3000 Bern 14 (CH)**

## Beschreibung

Die Erfindung betrifft eine Schaltungsanordnung entsprechend dem Oberbegriff von Anspruch 1.

Schaltungsanordnungen der genannten Art sind bekannt als Frequenz/Phasen-Detektoren, die in Phasenregelkreisen (phase locked loop, PLL) dem Frequenz- bzw. Phasenvergleich zwischen einem periodischen Eingangssignal und einem zum Vergleich dienenden Ausgangssignal eines spannungsgeregelten Oszillators dienen. Als Beispiel für derartige Frequenz/Phasen-Detektoren seien die integrierten Schaltkreise MC 4344 oder NC 4044 der Firma Motorola sowie die Patentschrift US-A-4 155 045 genannt.

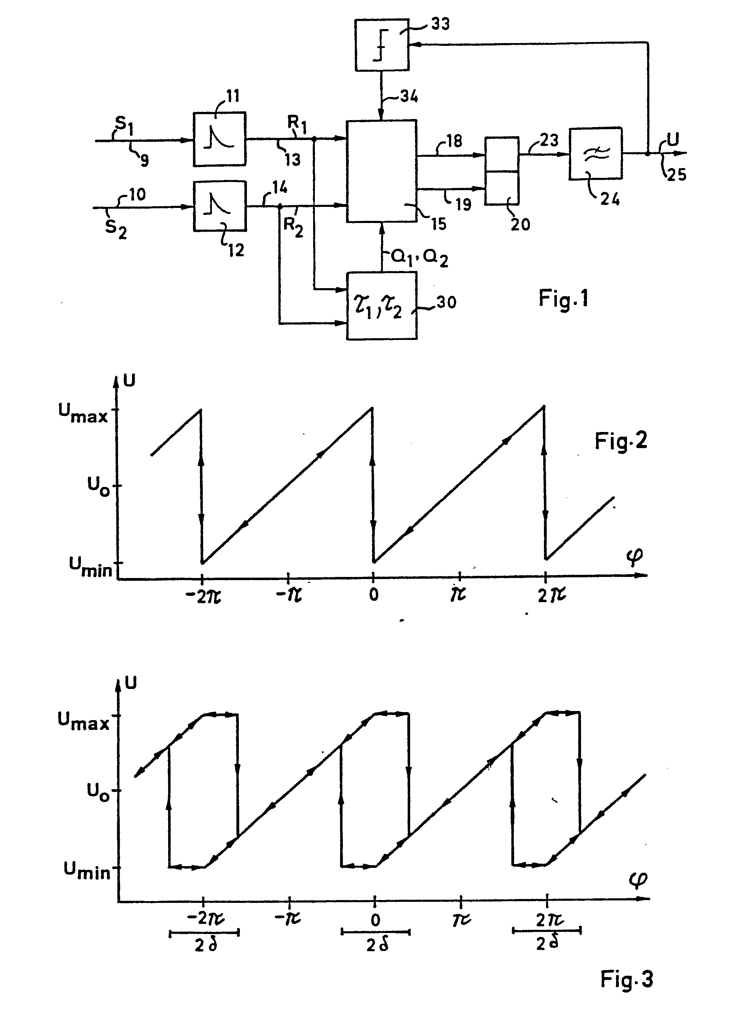

Frequenz/Phasen-Detektoren der einfachsten Art besitzen Spannung/Phasen-Kennlinien entsprechend Fig. 2. Diese Kennlinien sind periodisch mit linearem Anstieg zwischen den Phasendifferenzwerten $n \cdot 2\pi$ ($n = 0, \pm 1, \pm 2$). Im eingeregelten Zustand arbeiten solche Phasendetektoren einwandfrei. Schwierigkeit bereitet jedoch das Erreichen des eingeregelten Zustandes. Weiter besteht stets die Möglichkeit, dass bei zu grossen Phasenabweichungen Phasensprünge um $2\pi$ auftreten (cycle slips).

Die Aufgabe der vorliegenden Erfindung besteht darin, eine einfache Schaltungsanordnung anzugeben, die unabhängig von der Grösse des Frequenzunterschiedes und der Phase zwischen zwei periodischen Eingangssignalen stets eine eindeutige Steuerspannung abgibt. Diese Spannung soll einen Regelkreis so beeinflussen können, dass sich Frequenzgleichheit der Signale bei einer Phasendifferenz von $\pi$ herausbildet. Die Lösung dieser Aufgabe wird durch den kennzeichnenden Teil des ersten Patentanspruchs wiedergegeben. Die Ansprüche 2 bis 5 zeigen bevorzugte Ausführungsformen auf. Anspruch 6 macht schliesslich Angaben über die Verwendung der Schaltungsanordnung.

Die Schaltungsanordnung gibt stets eine eindeutige Regelspannung ab, so dass ein Phasenregelkreis selbständig einregeln kann. Hierbei ergibt sich der weitere Vorteil, dass bei Frequenzgleichheit der Bereich, innerhalb dessen Phasendifferenzen keinen Phasensprung bewirken, grösser als $2\pi$ ist.

Im folgenden wird die Erfindung anhand von fünf Figuren beispielsweise näher beschrieben. Es zeigen:

Fig. 1 Blockschaltbild einer prinzipiellen Schaltungsanordnung

Fig. 2 erstes Spannung/Phasendifferenz-Diagramm

Fig. 3 zweites Spannung/Phasendifferenz-Diagramm

Fig. 4 detailliertes Blockschaltbild der Schaltungsanordnung

Fig. 5 weiteres Blockschaltbild der Schaltungsanordnung.

Fig. 1 zeigt ein prinzipielles Blockschaltbild einer Schaltungsanordnung zur Erzeugung einer Regelspannung in Abhängigkeit von einer Frequenz- oder Phasendifferenz. 9 und 10 sind die Eingänge der Anordnung, über die zwei zu vergleichende periodische Eingangssignale $S_1$ und $S_2$ beliebiger Frequenz eingegeben werden. 11 und 12 sind Triggerschaltungen, die aus den Eingangssignalen in jeder Periode ein kurzes Triggersignal ableiten. Sind die Eingangssignale beispielsweise Rechtecksignale, so können die Schaltungen 11 und 12 Differenzierschaltungen sein, die aus den Signal-Anstiegsflanken Triggerimpulse ableiten. Sind die Eingangssignale sinusförmige Signale, so können die Schwellwertdetektoren als Schmitt-Trigger ausgebildet sein, die bei ihrem Ansprechen kurze Impulse abgeben.

20 ist ein Flipflop, dessen beide Eingänge 18 und 19 über eine Sperrschaltung 15 mit den Ausgängen 13 bzw. 14 der Triggerschaltungen 11 bzw. 12 verbunden sind. Die über die Eingänge 18 bzw. 19 ankommenden Triggersignale dienen zum Setzen bzw. zum Rücksetzen des Flipflops 20. Am Ausgang 23 des Flipflops entsteht hierdurch eine Rechteckfolge, deren relative Ein- und Ausschaltzeiten (duty cycle) von der Differenz der Frequenzen der Eingangssignale bzw. von der Phasendifferenz $\varphi$ der Triggersignale an den Flipflop-Eingängen abhängen. 24 ist eine Mittelungsschaltung, beispielsweise ein Tiefpass, die eine Regel-Gleichspannung U abgibt, die dem zeitlich gemittelten Verhältnis der Ein- und Ausschaltzeiten entspricht.

Sieht man von der Sperrschaltung 15 ab, so entspricht die bisher beschriebene Schaltungsanordnung einem bekannten Frequenz/Phasen-Detektor, der an seinem Ausgang 25 eine Regelspannung U abgibt, die entsprechend Fig. 2 mit der Phasendifferenz $\varphi$ sägezahnförmig verknüpft ist. Sich periodisch wiederholende Linearbereiche erstrecken sich über jeweils einen Phasendifferenzbereich von $2\pi$. Bei jeweils $\varphi = n \cdot 2\pi$ ($n = 0, \pm 1, \pm 2, \pm 3 \ldots$) tritt ein Sprung von $U_{max}$ nach $U_{min}$ bzw. umgekehrt auf. Eine sprungfreie Phasenregelung ist damit innerhalb eines Phasendifferenzbereichs von $2\pi$ möglich. Bei jeweils $\varphi = (2n-1) \cdot \pi$ ist die Regelspannung U gleich einem mittleren Spannungswert $U_o$, der gleichlangen Ein- und Ausschaltzeiten entspricht.

Sind die Frequenzen der Eingangssignale ungleich, so treten innerhalb der Perioden $2\pi$ keine konstanten Zeit- oder Phasendifferenzen zwischen den beteiligten Triggersignalen auf. In diesem Fall bildet sich am Ausgang 25 keine Gleichspannung U heraus, deren Wert eine eindeutige Steuerrichtung signalisiert. Die Spannung U eignet sich damit nicht für Frequenz-Regelzwecke.

Fig. 3 zeigt ein erfindungsgemässes Gleichspannung/Phasendifferenz-Diagramm, das diesen Nachteil nicht aufweist. In den Phasendifferenz-Bereichen von $\varphi = n \cdot 2\pi \pm \delta$ ($n = 0, \pm 1, \pm 2 \ldots$) zeigt das Diagramm eine hysteresisförmige Aufspaltung. Die Einzelnen Kurvenzweige können dabei entsprechend den Pfeilrichtungen durchlaufen werden. Eine Schaltungsanordnung, die eine derartige Charakteristik aufweist, liefert stets eine eindeutige Frequenz- oder Phasenregelspannung U.

Erfindungsgemäss ergibt sich durch Hinzufügen von Einheiten 15, 30 und 33 zum bekannten Frequenz/Phasen-Detektor eine Anordnung, die eine Charakteristik entsprechend Fig. 3 aufweist. 30 ist ein Sperrintervall-Erzeuger, der zeitlich direkt anschliessend an die Triggersignale $R_1$ und $R_2$ Sperrintervalle $Q_1$ und $Q_2$ der Längen $\tau_1$ bzw. $\tau_2$ erzeugt. 33 ist ein Komparator, der angibt., ob die Regelspannung U grösser oder kleiner als der mittlere Span-

nungswert $U_o$ ist. Die bereits erwähnte Sperrschaltung 15 schliesslich sperrt aufgrund der Signale der genannten Einheiten 30 und 33 die Triggerimpulse $R_1$ und $R_2$ nach folgenden Regeln:

Ist die Regelspannung U kleiner als $U_o$ und fällt ein erster Triggerimpuls $R_1$ in ein auf einen zweiten Triggerimpuls $R_2$ folgendes Sperrintervall $\tau_2$, so wird dieser Triggerimpuls $R_2$ gesperrt.

- Ist die Regelspannung U grösser als $U_o$ und fällt ein zeiter Triggerimpuls $R_2$ in ein auf einen ersten Triggersimpuls $R_1$ folgendes Sperrintervall $\tau_1$, so wird dieser Triggerimpuls $R_2$ gesperrt.

Die Anordnung arbeitet wie folgt: Von den periodischen Eingangssignalen $S_1$ und $S_2$ werden durch die Triggerschaltungen 11 und 12 Triggersignale $R_1$ bzw. $R_2$ abgeleitet. Diese Signale lösen im Sperrintervall-Erzeuger 30 Sperrsignale $Q_1$ bzw. $Q_2$ aus, durch die die Signale auf den Leitungen 18 bzw. 19 für Zeiten $\tau_1$ bzw. $\tau_2$ gesperrt werden, sofern der Komparator 33 dies durch sein momentanes Ausgangssignal zulässt. Ist somit der Abstand zwischen den Triggerimpulsen auf den Leitungen 13 und 14 kleiner als $\tau_1$ oder $\tau_2$, so wird in diesem Fall der zeitlich später auftretende Triggerimpuls gesperrt und das Flipflop 20, das durch den zeitlich früheren Triggerimpuls gesetzt wurde, wird nicht rückgesetzt, sondern verbleibt in seiner Lage. Hierdurch ergibt sich am Flipflop-Ausgang 23 ein verändertes Rechtecksignal oder zeitweise sogar ein Dauersignal mit einer entsprechenden Veränderung der Regelspannung U am Ausgang 25.

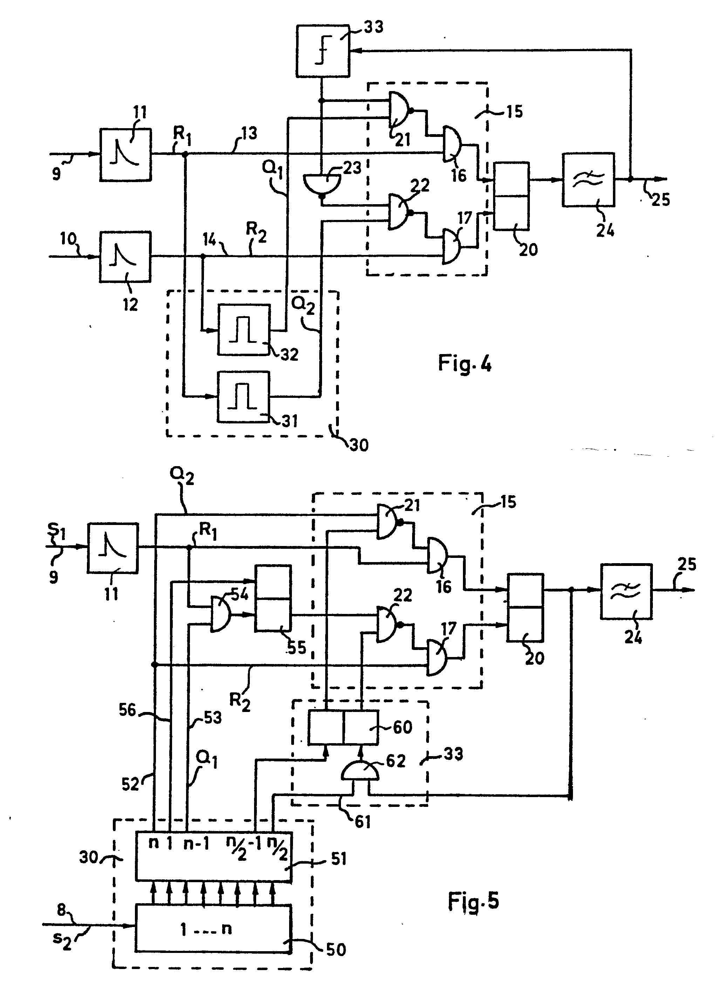

Fig. 4 zeigt ein detailliertes Blockschaltbild der Schaltungsanordnung. Danach wird der Sperrintervall-Erzeuger 30 aus zwei Monoflops 31 und 32 gebildet, die, getriggert durch die Triggersignale $R_1$ bzw. 2, rechteckförmige Sperrsignale konstanter Länge $\tau_1$ und $\tau_2$ liefern. Diese Signale werden zwei Kombinationen von UND-NICHT-Toren 21, 22 und UND-Toren 16, 17 zugeführt, die die Sperrschaltung 15 bilden. Als Komparator 33 dient ein Spannungsvergleicher, der an den Ausgang 25 angeschlossen ist. Er liefert sein Ausgangssignal nicht invertiert an das Tor 21 und über einen Inverter 23 invertiert an das Tor 22.

Fig. 5 zeigt ein weiteres Blockschaltbild mit einem Sperrintervall-Erzeuger 30, bei dem die Länge der Sperrintervalle $\tau_1$ und $\tau_2$ unabhängig von der Frequenz des Eingangssignals $S_2$ einen festen Bruchteil der jeweiligen Signalperiode beträgt. $S_2$ ist ein Hilfssignal, das am Eingang 8 anliegt und eine Frequenz aufweist, die um einen festen Faktor n höher ist als die des Signals $S_2$. Das Hilfssignal $s_2$ wird in einem Zähler 50 um den Faktor n untersetzt. 51 ist ein Decoder, der, wenn der Zähler 50 bestimmte Zählwerte erreicht, jeweils für eine Intervalldauer 1/n anspricht und dabei jeweils auf eine separate Leitung ein Signal entsprechender Länge abgibt.

Auf der Leitung 52 erscheint bem Zählerstand n das Sperrsignal $Q_2$, welches dem UND-NICHT-Tor 21 als Sperrintervall $\tau_2$ und dem UND-Tor 17 als Triggersignal $R_2$ zugeführt wird. Beim Zählerstand n-1 erscheint auf der Leitung 53 das Sperrsignal $Q_1$, welches bei Koinzidenz mit einem Triggersignal $R_1$ über ein UND-Tor 54 ein Flipflop 55 setzt. Bei einem Zählerstand n + 1, der dem Zählerstand 1 der nächsten Zählperiode entspricht, wird über die Leitung 56 das Flipflop 55 rückgesetzt.

60 ist ein weiteres Flipflop, welches zur Anzeige dafür dient, wie während der jeweiligen Signal-Periode die relative Ein- und Ausschaltzeit (duty cycle) des Flipflops 20 verteilt ist. Es ersetzt damit den Komparator 33. Das Flipflop 60 wird beim Erreichen des Zählerstandes n/2 mittels eines auf die Leitung 61 abgegebenen Nadelimpulses und über ein UND-Tor 62 entsprechend der Stellung des Flipflops 20 gesetzt bzw. nicht gesetzt. Beim Zählerstand n/2-1 wird das Flipflop 60 jeweils rückgesetzt. Die anderen Schaltungsteile entsprechen denen von Fig. 1 und 4.

Die Schaltungsanordnung zur Erzeugung einer Regelspannung in Abhängigkeit von einer Frequenz- oder Phasendifferenz ist als Frequenz/Phasen-Detektor einsetzbar in Phasenregelkreisen (phase locked loops). Im Falle der letztgeschilderten Variante kann dabei das Hilfssignal $s_2$ auf einfachste Weise durch den spannungsgeregelten Oszillator erzeugt werden, der mit einer Frequenz schwingt, die um einen festen Faktor n höher ist als die gewünschte Signalfrequenz $S_2$. Der Phasenregelkreis wird in jedem Fall so gesteuert, dass sich die Frequenz des durch den spannungsgeregelten Oszillator erzeugten Signals (beispielsweise $S_1$) der Frequenz des zweiten Signals $S_2$ annähert und dass sich bei Frequenzgleichheit eine Phasendifferenz von $\varphi = \pi$ einstellt.

**Patentansprüche**

1. Schaltungsanordnung zur Erzeugung einer Regelspannung (U) in Abhängigkeit von einer Frequenz- oder Phasendifferenz ($\varphi$) zwischen einem ersten ($S_1$) und einem zweiten ($S_2$) periodischen Signal beliebiger Frequenz,

— mit einem Flipflop (20), an dessen einen Eingang (18) das erste Signal ($S_1$) über eine erste Triggerschaltung (11) bei jeder seiner Perioden ein erstes Triggersignal ($R_1$) zum Setzen und an dessen zweiten Eingang (19) das zweite Signal ($S_2$) über eine zweite Triggerschaltung (12) bei jeder seiner Perioden ein zweites Triggersignal ($R_2$) zum Rücksetzen des Flipflops (20) abgibt,

— und mit einer dem Flipflop (20) nachgeschalteten Mittelungsschaltung (24) zur Abgabe der Regelspannung (U), die bei Frequenzgleichheit in jedem Phasendifferenz-Intervall von 0 bis $2\pi$ [n $\cdot$ $2\pi < \varphi < (n+1) \cdot 2\pi$; n = 0, 1, 2, 3 . . .] eine stetige, variable Funktion der Phasendifferenz ($\varphi$) mit einem mittleren Wert ($U_o$) bildet, dadurch gekennzeichnet,

— dass dem Flipflop (20) ein Komparator (33) zugeordnet ist, der an seinem Ausgang (34) Steuersignale abgibt, die angeben, ob die Regelspannung (U) grösser oder kleiner als der mittlere Wert ($U_o$) ist,

— dass den Triggerschaltungen (11, 12) ein Sperrintervall-Erzeuger (30) zugeordnet ist, der zeitlich unmittelbar an die Triggersignale ($R_1$, $R_2$) angrenzende erste ($\tau_1$) und zweite ($\tau_2$) Sperrintervalle erzeugt, und

— dass zwischen die erste (11) und zweite (12) Triggerschaltung und das Flipflop (20) eine Sperrschaltung (15) eingeschaltet ist, die, sofern die Regelspannung (U) grösser als der mittlere Wert (U_o) ist, jedes zweite Triggersignal (R_2) unterdrückt, das innerhalb eines ersten Sperrintervalls (τ_1) zeitlich auf ein erstes Triggersignal (R_1) nachfolgt, und die, sofern die Regelspannung (U) kleiner als der mittlere Wert (U_o) ist, jedes erste Triggersignal (R_1) unterdrückt, das innerhalb eines zweiten Sperrintervalls (τ_2) zeitlich auf ein zweites Triggersignal (R_2) nachfolgt.

2. Schaltungsanordnung nach Anspruch 1, dadurch gekennzeichnet,

— dass der Sperrintervall-Erzeuger (30) zwei Monoflops (31, 32) umfasst,

— dass die Sperrschaltung (15) aus logischen UND-Toren (16, 17), UND-NICHT-Toren (21, 22) gebildet ist,

— und dass die Mittelungsschaltung (24) ein Tiefpass ist (Fig. 4).

3. Schaltungsanordnung nach Anspruch 2, dadurch gekennzeichnet, dass die Monoflops (31, 32) Kippzeiten konstanter Dauer erzeugen.

4. Schaltungsanordnung nach Anspruch 2, dadurch gekennzeichnet, dass die Monoflops (31, 32) Kippzeiten aufweisen, deren Dauern stets einem gleichbleibenden Bruchteil der jeweiligen Periodendauern entsprechen.

5. Schaltungsanordnung nach Anspruch 1, dadurch gekennzeichnet,

— dass der Sperrventil-Erzeuger (30) einen Zähler (50) und einen diesem zugeordneten Decoder (51) umfasst, wobei der Zähler (50) ein gegenüber dem zweiten periodischen Signal (S_2) um einen ganzzahligen Faktor n höherfrequentes Hilfssignal (s_2) um den Faktor n untersetzt und der Decoder (51) beim jeweiligen Erreichen vorbestimmter Zählerstände diesen Zählerständen zugeordnete Zählsignale abgibt,

— dass die Sperrschaltung (15) ausser logischen Toren ein zweites Flipflop (55) umfasst, welches eine zeitliche Koinzidenz zwischen einem ersten Triggersignal (R_1) und einem durch ein erstes Zählsignal (n-1) bestimmten ersten Sperrintervall (τ_1) speichert und damit das zugeordnete, durch das unmittelbar auf das erste Zählsignal folgende zweite Zählsignal (n) bestimmte zweite Triggersignal (R_2) sperrt),

— und dass der Komparator (33) ein drittes Flipflop (60) umfasst, welches, nachdem es zuvor rückgesetzt ist, jeweils beim Auftreten eines dritten Zählsignals (n/2) den Kippzustand des ersten Flipflops (20), übernimmt (Fig. 5).

6. Verwendung der Schaltungsanordnung nach den Ansprüchen 1 bis 5 in einem Phasenregelkreis, der sich aus einem Frequenz-Phase-Detektor, einem Filter und einem spannungsabhängigen Oszillator zusammensetzt, dadurch gekennzeichnet, dass die Schaltungsanordnung am Filterausgang (25) eine Regelspannung (U) erzeugt, die den spannungsabhängigen Oszillator so steuert, dass sich die Frequenz des durch den Oszillator erzeugten ersten Signals (s_1) der Frequenz des zweiten Signals (S_2) annähert und dass bei Frequenzgleichheit eine Phasendifferenz (φ) von π entsteht.

**Claims**

1. Generator circuit for generating a regulating voltage (U) depending on a frequency or phase difference (φ) between a first (S_1) and a second (S_2) periodic signal of any frequency whatever,

— with a flipflop (20), to the first input (18) of which the first signal (S_1) for each of its cycles supplies via a first trigger circuit (11) a first trigger signal (R_1) for setting, and to the second input (19) of which the second signal (S_2) for each of its cycles supplies via a second trigger circuit (12) a second trigger signal (R_2) for resetting the flipflop (20),

— and with an averaging circuit (24) connected to the output of the flipflop (20) for supplying the regulating voltage (U) which at equal frequencies in every phase difference interval from 0 to $2\pi$ [$n \cdot 2\pi < \varphi < (n+1) \cdot 2\pi$; $n = 0, 1, 2, 3 \ldots$] forms a continuous, variable function of the phase difference (φ) with a mean value (U_o), characterized in,

— that allocated to the flipflop (20) is a comparator (33) which supplies at its output (34) control signals which indicate whether the regulating voltage (U) is greater or smaller than the mean value (U_o),

— that allocated to the trigger circuits (11, 12) is a blocking-interval generator (30) which generates a first (τ_1) and a second (τ_2) blocking interval immediately following the trigger signals (R_1, R_2), and

— that connected between the first (11) and the second (12) trigger circuit and the flipflop (20) is a blocking circuit (15), which, when the regulating voltage (U) is greater than the mean value (U_o), suppresses every second trigger signal (R_2) following a first trigger signal (R_1) within a first blocking interval (τ_1), and which, when the regulating voltage (U) is smaller than the mean value (U_o), suppresses every first trigger signal (R_1) following a second trigger (R_2) within a second blocking interval (τ_2).

2. Generator circuit according to claim 1, characterized in,

— that the blocking interval generator (30) consists of two monoflops (31, 32),

, — that the blocking circuit (15) consists of logical AND gates (16, 17) and NAND gates (21, 22),

— and that the averaging circuit (24) is a lowpass filter (Fig. 4).

3. Generator circuit according to claim 2, characterized in, that the monoflops (31, 32) generate switching intervals of constant length.

4. Generator circuit according to claim 2, characterized in, that the monoflops (31, 32) generate switching intervals whose lengths are always a constant fraction of the respective length of the periods.

5. Generator circuit according to claim 1, characterized in,

— that the blocking-interval generator (30) consists of a counter (50) and an associated decoder (51), whereby the counter (50) reduces by a factor of an integer n an auxiliary signal (s_2) having a frequency higher than the second periodic Signal (S_2) by a factor n, and whereby the decoder (51) supplies counter signals each time predefined counts are reached,

— that the blocking circuit (15) consists, in addition to logical gates, of a second flipflop (55) which stores a time coïncidence between a first trigger

signal ($R_1$) and a first blocking interval ($\tau_1$) which is determined by a first count signal (n - 1), and hence blocks the assigned second trigger signal ($R_1$) which is determined by the second count signal (n) following immediately after the first count signal (n - 1),

— and that the comparator (33) contains a third flipflop (60) which, after it is first reset, assumes the switching state of the first flipflop (20) each time a third count signal (n/2) occurs (Fig. 5).

6. Application of the generator circuit according to the claims 1 to 5 in a phase-locked loop consisting of a frequency/phase detector, a filter and a voltage-controlled oscillator, characterized in, that the generator circuit at the filter output (25) generates a regulating voltage (U) which controls the voltage-controlled oscillator in such a manner that the frequency of the first signal ($S_1$) generated by the oscillator approaches the frequency of the second signal ($S_2$) and that at frequency equality a phase difference ($\varphi$) of $\pi$ results.

**Revendications**

1. Circuit générateur pour l'obtention d'une tension de régulation (U) en fonction d'une différence de fréquence ou de phase ($\varphi$) entre un premier ($S_1$) et un second ($S_2$) signal périodique, choisis arbitrairement,

— avec un flipflop (20) à la première entrée (18) duquel le premier signal ($S_1$) délivre par un premier circuit de déclenchement (11) dans chacune de ses périodes un premier signal de déclenchement ($R_1$) pour basculer, et à la seconde entrée (19) duquel le second signal ($S_2$) délivre par un second circuit de déclenchement (12) dans chacune de ses périodes un second signal de déclenchement ($R_2$) pour basculer en arrière le flipflop (20).

— et avec un dispositif des moyennes (24) connecté à la sortie du flipflop (20) pour générer une tension de régulation (U) moyenne qui à l'égalité des fréquences dans chaque intervalle de différence de phase de 0 à 2$\pi$ [n · 2$\pi$ < $\varphi$ < (n+1) · 2$\pi$; n = 0, 1, 2, 3 . . .] présente une fonction continue variable de la différence de phase ($\varphi$) avec une valeur moyenne ($U_o$),
caractérisé en ce que
— au flipflop (20) est adjoint un comparateur (33) qui à sa sortie (34) émet des signaux de commande qui indiquent si la tension de régulation (U) est supérieure ou inférieure à la valeur moyenne ($U_o$).
— aux circuits de déclenchement (11, 12) est adjoint un générateur des intervalles de blocage (30) qui produit immédiatement après les signaux de déclenchement ($R_1$, $R_2$) de premiers ($\tau_1$) et de second ($\tau_2$) intervalles de blocage,
— et entre le premier (11) et le second (12) des circuits de déclenchement et le flipflop (20) est inséré un circuit de blocage (15) qui, dès que la tension de régulation (U) est supérieure à la valeur moyenne ($U_o$), affaiblit chaque second signal de déclenchement ($R_2$) qui suit à l'intérieur d'un premier intervalle de blocage ($\tau_1$) un premier signal de déclenchement ($R_1$), et qui, dès que la tension de régulation (U) est inférieure à la valeur moyenne ($U_o$), affaiblit chaque premier signal de déclenchement ($R_1$) qui suit à l'intérieur d'un second intervalle de blocage ($\tau_2$) un second signal de déclenchement ($R_2$).

2. Circuit générateur suivant la revendication 1, caractérisé en ce que
— le générateur des intervalles de blocage (30) comprend deux multivibrateurs monostables (31, 32),
— le circuit de blocage (15) est formé de portes logiques ET (16, 17) et de portes NON-ET (21, 22),
— et le dispositif (24) pour générer la tension de régulation (U) moyenne est un passe-bas (figure 4).

3. Circuit générateur suivant la revendication 2, caractérisé en ce que les multivibrateurs monostables (31, 32) produisent des temps de basculement de durée constante.

4. Circuit générateur suivant la revendication 2, caractérisé en ce que les multivibrateurs monostables (31, 32) produisent des temps de basculement dont les durées correspondent toujours à une fraction qui reste identique des durées des périodes.

5. Circuit générateur suivant la revendication 1, caractérisé en ce que
— le générateur des intervalles de blocage (30) comprend un compteur (50) et un décodeur (51) qui lui est subordonné, le compteur (50) divisant d'un facteur n (n = 1, 2, 3 . . .) un signal auxiliaire ($s_2$) dont la fréquence est plus haute d'un facteur n que le second signal périodique ($S_2$), et le décodeur (51) fournissant des signaux de comptage adjoint à des valeurs déterminées chaque fois que le compteur (50) atteint ces valeurs,
— le circuit de blocage (15), en dehors de portes logiques, comprend un second flipflop (55) qui enregistre toute concidence entre un premier signal de déclenchement ($R_1$) et un premier intervalle de blocage ($\tau_1$) déterminé par un premier signal de comptage (n - 1) et qui arrête le second signal de déclenchement ($R_2$) adjoint, qui est déterminé par le second signal de comptage (n) suivant directement le premier signal de comptage (n - 1),
— et le comparateur (33) comprend un troisième flipflop (60) qui, après avoir d'abord été remis à l'état initial, prend l'état du premier flipflop (20) chaque fois qu'un troisième signal de comptage (n/2) est arrivé (figure 5).

6. Utilisation du circuit générateur suivant les revendications 1 à 5 dans un circuit de réglage de phase qui est composé d'un détecteur de fréquence/phase, d'un filtre et d'un oscillateur dépendant de la tension, caractérisé en ce que le circuit produit une tension de régulation (U) à la sortie du filtre (25), qui dirige l'oscillateur dépendant de la tension de telle façon que la fréquence du premier signal ($S_1$) produit par l'oscillateur approche de la fréquence du second signal ($S_2$) et que par l'égalité des fréquences il se produit une différence de phase ($\varphi$) de $\pi$.

Fig.1

Fig.2

Fig.3

Fig. 4

Fig. 5